Europäisches Patentamt

(19) European Patent Office

Office européen des brevets

(11) Publication number: **0 003 079**
**B1**

## EUROPEAN PATENT SPECIFICATION

(45) Date of publication of patent specification:
01.04.81

(21) Application number: **78300858.4**

(22) Date of filing: **19.12.78**

(51) Int. Cl.³: **H 01 L 33/00, H 01 S 3/19**

(54) **Infra red light emissive devices.**

(30) Priority: **11.01.78 GB 97978**

(43) Date of publication of application:
**25.07.79 Bulletin 79/15**

(45) Publication of the grant of the patent:
**01.04.81 Bulletin 81/13**

(84) Designated Contracting States:
**DE FR NL**

(56) References cited:
**FR-A-2 103 571**
**SOVIET JOURNAL OF QUANTUM ELECTRONICS, vol. 6, no. 1, January 1976**
**London, G.B.**
**S.A. BONDAR et al. "Electron-Beam-pumped semiconductor laser utilizing multilayer $Ga_{1-x}In_xAs_{1-y}Sb_y$ heterostructures", pages 50–53**
**SOVIET JOURNAL OF QUANTUM ELECTRONICS, vol. 6, no. 4, April 1976**
**London, G.B.**
**L.M. DOLGINOV et al. "Luminescense and stimulated emission from $Ga_xIn_{1-x}As_ySb_{1-y}$", pages 507–508**

(73) Proprietor: **International Standard Electric Corporation, 320 Park Avenue, New York New York 10022 (US)**

(72) Inventor: **Goodman, Charles Howard Ludlow, 55 Spareleaze Hill, Loughton Essex (GB)**

(74) Representative: **Dennis, M.C. et al, ITT-UK Patent Department Maidstone Road, Foots Cray Sidcup DA14 5HT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Infra red light emmisive devices

This invention relates to infra-red light emissive devices, and in particular to such devices having active light emissive regions of the ternary solid solution In (Sb,As) and related multicomponent (quarternary or higher) solid solutions. Light emissive devices have been made that had an active light emissive region of In (Sb,As) grown epitaxially upon an In As substrate. A problem with this type of construction is that the addition of InSb or InAs to form a solid solution has the effect of changing the lattice spacing. Therefore a graded interlayer was necessary between the active region and the substrate, but even this did not entirely remove the strain from the active region which was relatively heavily dislocated.

In an article entitled 'Electron-beam-pumped semiconductor laser utilizing multilayer $Ga_{1-x}In_xAs_{1-y}Sb_y$ heterostructures' appearing in the Soviet Journal of Quantum Electronics, Volume 6 No. 1 January 1976 pages 50 to 53 by S. A. Bondar et al there is a reference to the possibility of growing lattice matched $Ga_{1-x}In_xAs_{1-y}Sb_y$ solid solutions on substrates of GaSb and InAs. Some work in this field is also reported by L. M. Dolginov et al in an article entitled 'Luminescence and stimulated' emission from $Ga_xIn_{1-x}As_ySb_{1-y}$ appearing in the Soviet Journal of Quantum Electronic, Volume 6 No. 4 April 1976 pages 507 to 508.

GaSb has a higher band gap than In (Sb,As), and therefore if a device is made that has a p-n junction formed in a layer of lattice matched In (Sb,As) epitaxially grown upon a GaSb substrate, the heterojunction formed between the epitaxial material and the substrate will confine minority carriers injected across the p-n junction towards the substrate. This confinement of minority carriers is also present at the heterojunctions of heterostructure lasers based on (Al,Ga) As, but the heterojunction in the (Al,Ga) As device has the added advantage that it also provides optical confinement because the higher band-gap material has a lower refractive index. The converse is true in the case of a heterojunction between lattice matched In (Sb,As) and GaSb, with the result that such a heterojunction does not provide the optical waveguiding properties desired particularly for laser action.

The present invention relates to infra-red light emissive devices in which the active material of the device is In (Sb,As) that is lattice matched with a GaSb substrate directly or indirectly supporting the active material and in which the active material is flanked upon at least one side with a lattice matched layer of (Al,Ga) Sb that has a composition providing it with a refractive index less than that of the active material. In this way the active material of the device is bounded on at least one side by a heterojunction that provides not only minority carrier confinement but also optical confinement.

The invention is applicable not only to infra-red light emissive devices whose active material consists of the ternary In (Sb,As) solid solution, but also to those whose active material consist of quarternary and higher solid solutions based on In (Sb,As) and also having a lattice spacing matched with that of GaSb.

GaSb has the same lattice constant as a particular compound of In (Sb,As), approximately In $(Sb_{0.1}As_{0.9})$, therefore In $(Sb_{0.1}As_{0.9})$ grown on a GaSb substrate is substantially strain free.

There follows a description of infra-red light emissive devices embodying the invention in preferred forms. To assist the understanding of the invention the description of the preferred embodiments of the invention is prefaced with an explanation which includes reference to a device of a construction for which patent protection is not sought. The description refers to the accompanying rawings in which:

Figure 1 is a graph depicting the variation of lattice spacing and band-gap with composition for a number of ternary solid solutions of compound semiconductors,

Figure 2 depicts a schematic cross-section through a light emissive diode construction for which patent protection is not sought,

Figure 3 is a graph depicting the variation in dielectric constant of the (A1,Ga)Sb solid solution with composition, and

Figures 4 and 5 depict schematic cross-sections through two constructions of device embodying the present invention in preferred forms.

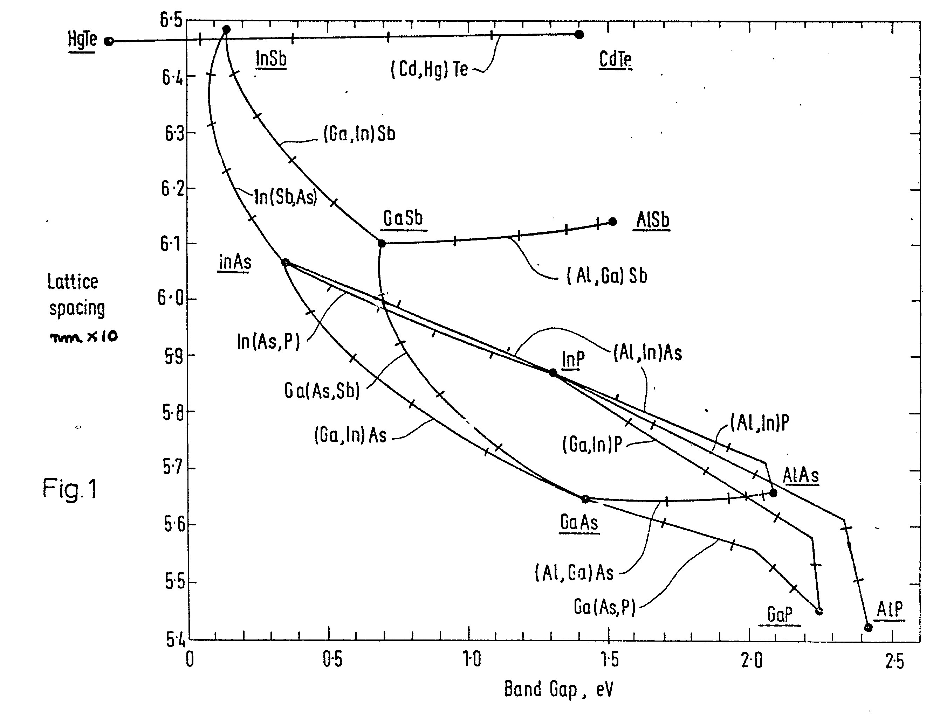

Referring to Figure 1, and in particular to the In (Sb,As) line between InAs and InSb, it can be seen that the addition of progressively more InSb to InAs has the effect of progressively increasing the lattice spacing at a relatively rapid rate. (The four hatchings on this line, and each of the others, mark the 20, 40, 60 and 80% points respectively.)

The rate of increase in lattice spacing is for instance much more rapid than that produced by adding Al As to Ga As to form (Al,Ga) As. This shows why the growth of In (Sb,As) upon an In As substrate is much more difficult than growing (Al,Ga) As upon a substrate of Ga As.

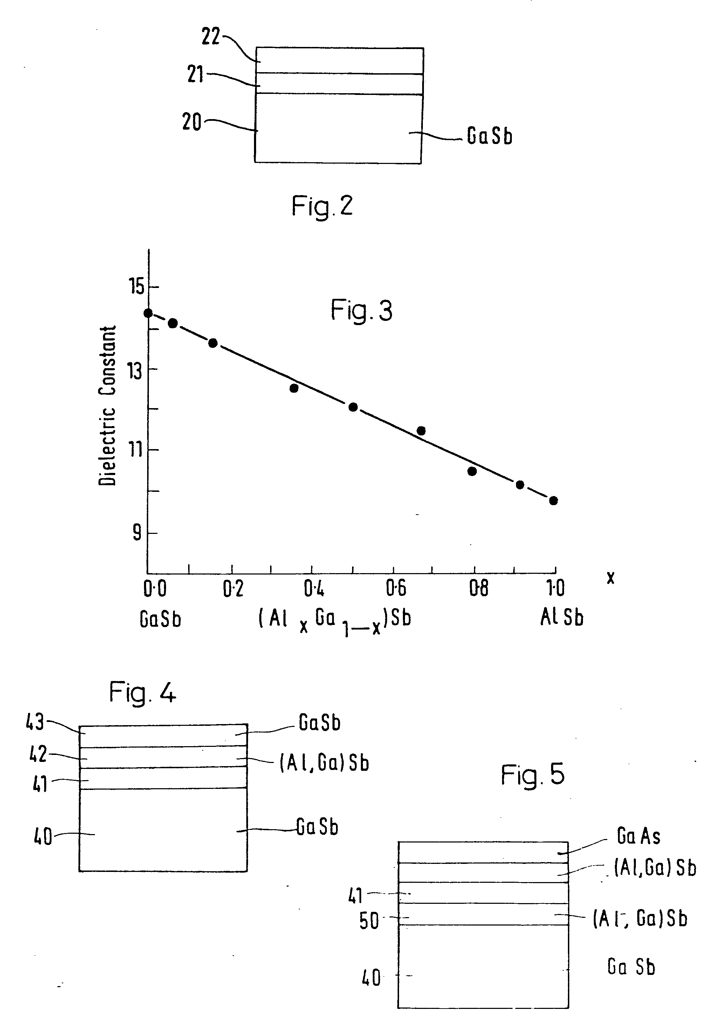

However, also from Figure 1 it is seen that Ga Sb has the same lattice constant as a particular point on the In (Sb,As) line corresponding approximately to In $(Sb_{0.1}As_{0.9})$. Therefore substantially strain free In $(Sb_{0.1}As_{0.9})$ can be grown upon a Ga Sb substrate. This enables structures of the type depicted schematically in Figure 2 to be grown. A Ga Sb substrate 20 of one conductivity type is provided, and then the material of layers 21 and 22 is grown epitaxially upon the substrate 20. Layer 21 has the same conductivity type as the substrate while layer 22 is arranged to have the opposite conductivity type in order to form a p-n junction between them. The growth may be performed by the conventional methods of compound semiconductor material epitaxy. We prefer to use liquid phase epitaxy, and to use for this purpose a graphite slider boat system. From Figure 1 it can be seen that In $(Sb_{0.1}As_{0.9})$ has a band gap of about 0.3 eV and therefore the radiation produced in the vicinity of a p-n junction formed in this material will be at a wavelength of about 4µm.

The actual value of the emission wavelength may be shifted by going from the ternary In (Sb,As) solid solution to a quaternay or higher solid solution by increasing the proportion of In Sb and adding a further compound semiconductor material in sufficient quantity to restore the lattice spacing to its original value matching that of Ga Sb. To a first approximation the rate of change of lattice spacing and of band gap provided by adding a certain proportion of for instance Ga As to In (Sb,As) is the same as adding that proportion of Ga As to In As. In other words, referring to Figure 1, the effect of adding Ga As to In (Sb,As) is to a first approximation given by a translation of the (Ga,In) As curve so that its In As end lies on the appropriate part of the In (Sb,As) curve. It is to be noted that the In (Sb,As) curve is not so steep at its lower end as the top end of the (Ga,In)As curve. Therefore, by increasing the proportion of In Sb in In (Sb,As) above In $(Sb_{0.1}As_{0.9})$ and then adding sufficient Ga As to restore the lattice spacing to the In $(Sb_{0.1}As_{0.9})$ value, it can be seen that the band gap is reduced and hence the emission wavelength increased. Conversely it can be seen that, because the In (As,P) curve and the (Al,In) As curve are neither as steep as the In (As,Sb) curve, the compensation of additional in Sb with the appropriate amount of in P or Al P will have the effect of increasing the band gap and hence reducing the emission wavelength.

Therefore the device of Figure 2 may employ multicomponent, quaternary or higher, solid solution epitaxial layers 21 and 22 in order to provide a wavelength of emission greter or less than that of the ternary In (Sb,As) composition with a lattice spacing matching that of Ga Sb. This multicomponent solid solution will be one having a lattice spacing matched with that of Ga Sb and based upon the ternary In (Sb, As) system.

It will be noted that Ga Sb has a higher band gap than In (Sb,As) and therefore the heterojunction formed between the substrate 20 and layer 21 will serve to confine minority carriers. For some applications it may therefore be advantageous similarly to confine minority carriers on the opposite side of the p-n junction by the use of an additional layer (not shown in Figure 2) of Ga Sb on top of layer 22.

By analogy with injection lasers based on (Al, Ga) As it might superficially be expected that it should be possible to construct a laser with an In (Sb,As) layer sandwiched between a pair of layers of Ga Sb. However although the two heterojunctions of such a structure are effective in confining minority carriers they do not provide the requisite optical guidance. This is because the refractive index of Ga Sb (3.83 at 4µm) is greater than that of In As (3.51 at 4µm) and greater than that of In (Sb,As). This problem may be resolved by the use of (Al,Ga)Sb in place of Ga Sb. Figure 3 depicts the variation of optical frequency dielectric constant (equal to the square of the refractive index) for different compositions in the (Al, Ga)Sb solid solution. In order to provide optical confinement at a heterojunction the material bounding the active region must have a refractive index less than that of the active region, preferably about 1% less. Therefore by adding Al Sb to Ga Sb it is possible to reduce the refractive index to an acceptable value. Typically this will occur in the region of $(Al_{0.6}Ga_{0.4})Sb$. (Al,Ga) Sb appears to be more stable than (Al,Ga)As with respect to atmospheric attack, and it is found that $(Al_{0.6}Ga_{0.4})Sb$ is stable in air at room temperature. Referring again to Figure 1, it is seen that the lattice spacing of (Al,Ga)Sb and (Al,Ga)As both change with composition at substantially the same slow rate. Therefore, with an active region lattice spacing matched with that of Ga Sb, it is possible, without introducing undue strain, to vary the composition of (Al,Ga)Sb within relatively wide limits so as to adjust the strengt of optical guidance to the desired value.

Figure 4 depicts a laser which embodies the invention in a preferred form and which is functionally analogous with the single heterostructure (A1,Ga)As laser. The laser is grown by epitaxy upon a Ga Sb substrate 40 and includes two, or optionally three, epitaxial layers 41, 42 and 43. Layer 41 has the opposite conductivity type to that of the substrate 40, and is made of material having the same lattice spacing as the substrate and it is made of In(Sb,As) or of a multicomponent, quaternary or higher, solid solution based on In(Sb,As). Layer 42 has the same conductivity type as layer 41, and is made of (A1,Ga)Sb containing a sufficient proportion of Al Sb to reduce ist refractive index beneath that of layer 41 so as to provide the requisite amount of optical confinement in addition to minority carrier confinement. Layer 43 has the same conductivity type as layer 42 and is an optional capping layer of Ga Sb which may be provided to protect the underlying layer 42 from atmospheric attack. This will be the more necessary if layer 42 contains a particularly large proportion of Al Sb which would make it more vulnerable to atmospheric attack. In this construction the heterojunction formed between the substrate 40 and layer 41 merely provides electrical confinement whereas that between layers 41 and 42 provides both electrical and optical confinement.

Figure 5 depicts a laser which embodies the invention in an alternative preferred which is functionally analogous with the double heterostructure(Al,Ga)As laser. This is essentially similar to that previously described with reference to Figure 4, but includes an additional layer 50 of (Al, Ga)As of the same conductivity type as the substrate 40 which is located between the substrate and layer 41 which in this instance may have either conductivity type. This layer 50 is of a composition providing it with a refractive index the desired amount less than that of layer 41 to provide the requisite optical guidance. In this way electrical and optical confinement is provided at both the heterojunctions flanking the active region provided by layer 41.

The constructions depicted do not show any particular means for lateral confinement of photons or minority carriers in the active light emissive region. It will however be readily apparent that many of the techniques developed for such confinement in relation to (Al,Ga)As solid solutions will be applicable with little or no modifications to semiconductor devices constructed in accordance with the teachings of the present invention.

1. An infra-red light emissive device having a Ga Sb substrate supporting epitaxially grown material having a lattice spacing matched with that of GaSb which material includes an active light emissive region of the ternary In(Sb,As) solid solution or of a multicomponent, quaternary or higher, solid solution based on In(Sb,As), characterised in that the active region is directly flanked upon at least one side by a part of said epitaxially grown material consisting of a layer of (Al,Ga)Sb having a composition that provides said layer with a refractive index less than that of the active region.

2. An infra-red light emissive device as claimed in claim 1 characterised in that the active region is sandwiched between two layers of (Al,Ga)Sb, each forming a part of said epitaxially grown material, and each having a composition that provides it with a refractive index less than that of the active region.

3. An infra-red light emissive device as claimed in claim 1 or 2 characterised in that the active region is of (Ga,In) (Sb,As).

4. An infra-red light emissive device as claimed in claim 1 or 2 characterised in that the active region is of (Al,In) (Sb,As).

5. An infra-red light emissive device as claimed in claim 1 or 2 characterised in that the active region is of In(Sb, As,P).

6. An infra-red light emissive device as claimed in any preceding claim characterised in that the device is constructed for laser operation.

## Patentansprüche

1. Infrarotlicht emittierende Vorrichtung mit einem GaSb-Substrat, das epitaxial aufgewachsenes Material trägt, welches einen Gitterabstand hat, der mit dem von GaSb vergleichbar ist und das Material eine aktive, Licht emittierende Zone aus der ternären festen Lösung In (Sb,As) oder einer festen Lösung aus einem Vielkomponentenmaterial, quarternärer oder höherer Zusammensetzung, auf der Basis von In(Sb,As) besitzt, dadurch gekennzeichnet, dass die aktive Zone mindestens auf einer Seite direkt an einen Teil des epitaxial aufgewachsenen Materials angrenzt, das aus einer Schicht aus (Al,Ga)Sb besteht und eine solche Zusammensetzung hat, dass der Brechungsindex der Schicht kleiner ist als der der aktiven Zone.

2. Infrarotlicht emittierende Vorrichtung nach Anspruch 1, dadurch gekennzeichnet, dass die aktive Zone zwischen zwei Schichten aus (Al, Ga)Sb angeordnet ist, von denen jede einen Teil des epitaxial aufgewachsenen Materials bildet und jede eine solche Zusammensetzung hat, dass ihr Brechungsindex kleiner ist als der der aktiven Zone.

3. Infrarotlicht emittierende Vorrichtung nach Anspruch 1 oder 2, dadurch gekennzeichnet, dass die aktive Zone aus (Ga,In) (Sb,As) besteht.

4. Infrarotlicht emittierende Vorrichtung nach Anspruch 1 oder 2, dadurch gekennzeichnet, dass die aktive Zone aus (Al,In) (Sb,As) besteht.

5. Infrarotlicht emittierende Vorrichtung nach Anspruch 1 oder 2, dadurch gekennzeichnet, dass die aktive Zone aus In(Sb,AS,P) besteht.

6. Infrarotlicht emittierende Vorrichtung nach einem der vorhergehenden Ansprüche, dadurch gekennzeichnet, dass die Vorrichtung zum Betrieb mit Laserstrahlen ausgebildet ist.

## Revendications

1. Dispositif luminescent à radiation infrarouge comprenant un substrat en GaSb supportant un matériau déposé par croissance épitaxiale dont l'espacement réticulaire correspond à celui du GaSb, ce matériau incluant une région luminescente active faite de la solution solide ternaire In(Sb,As) ou d'une solution à plus grand nombre d'éléments, quaternaire ou supérieure, basée sur l'In(Sb,As), caractérisé en ce que le région active est directement flanquée sur l'un au moins de ses côtés par une partie duduit matériau déposé par croissance épitaxiale consistant en une couche de (Al,Ga)Sb ayant une composition qui lui confère un indice de réfraction inférieur à celui de la région active.

2. Dispositif luminescent à radiation infrarouge tel que défini en 1, caractérisé en ce que la région active est comprise entre deux couches de (Al, Ga)Sb, faisant chacune partie dudit matériau déposé par croissance épitaxiale et ayant chacune une composition qui lui confère un indice de réfraction inférieur à celui de la région active.

3. Dispositif luminescent à radiation infrarouge tel que défini en 1 ou 2, caractérisé en ce que la région active est en (Ga,In) (Sb,As).

4. Dispositif luminescent à radiation infrarouge tel que défini 20 en 1 ou 2, caractérisé en ce que la région active est en (Al,In) (Sb,As).

5. Dispositif luminescent à radiation infrarouge tel que défini en 1 ou 2, caractérisé en ce que la région active est en In(Sb,As,P).

6. Dispositif luminescent à radiation infrarouge tel que défini dans l'une quelconque des revendications 1 à 5, caractérisé en ce que ce dispositif est construit pour un fonctionnement en laser.

Fig. 1

Lattice spacing nm × 10

Band Gap, eV

000 3079

Fig. 2

Fig. 3

Fig. 4

Fig. 5